# EUROPÄISCHE PATENTSCHRIFT

(11) **EP 0 468 072 B1**
(45) Veröffentlichungstag und Bekanntmachung des Hinweises auf die Patenterteilung: **22.02.1995**
(21) Anmeldenummer: 90114273.7
(22) Anmeldetag: 25.07.1990
(51) Int. Cl.: H03G 11/00, H04R 25/00

(54) **Hörgeräteschaltung mit einer Endstufe mit einer Begrenzungseinrichtung**
Hearing aid comprising an output amplifier with a limiting circuit
Aide à l'audition comportant un amplificateur de sortie avec circuit limiteur

(43) Veröffentlichungstag der Anmeldung: 29.01.1992
(73) Patentinhaber: Siemens Audiologische Technik GmbH, 91058 Erlangen (DE)
(72) Erfinder: Krauss, Gerhard, Dipl.-Ing. FH, D-8500 Nürnberg (DE)
(74) Vertreter: Fuchs, Franz-Josef, Dr.-Ing.

(56) Entgegenhaltungen:
- EP-A- 0 237 203
- WO-A-89/08353
- FR-A- 2 527 925
- GB-A- 2 166 015

## Beschreibung

Die Erfindung betrifft eine Hörgeräteschaltung mit einer Endstufe, die über einen Hörer und eine Batterie zu einem Stromkreis verbindbar ist, der zur Begrenzung des maximalen akustischen Ausgangspegels des Hörers eine einstellbare Begrenzungseinrichtung aufweist.

Bei bekannten Hörgeräteschaltungen der eingangs genannten Art ist die elektronische Begrenzungseinrichtung - auch als "Peak-Clipping = PC" bezeichnet - als mechanischer Steller ausgeführt. Der Steller wirkt als einstellbarer zweipoliger Widerstand im Stromkreis der Endstufe zwischen der Batterie und dem Hörer.

Es sind auch programmierbare elektronische Stellerwiderstände bekannt. Der Steller ist regelmäßig mit unipolaren Transistoren (FET) gebildet. Der elektronische Steller läßt sich im Gegensatz zu einem mechanischen Steller nicht auf einen Widerstandswert von oder annähernd null Ohm einstellen. Folglich würde an dem programmierbaren elektronischen Steller bei Verwendung als PC-Steller auch bei unwirksam gestellter Begrenzung (entspricht dem geringsten Widerstand des Stellers) ein Spannungsabfall entstehen. Weil einerseits der Strombedarf der Endstufe in dieser Einstellung am größten ist und andererseits die Betriebsspannung an Hörgeräteschaltungen für insbesondere am Kopf tragbare Hörgeräte üblicherweise nur etwa 1,3 V beträgt, würde der mit steigendem Strom linear steigende Spannungsabfall zu einer deutlichen Verringerung des maximal erreichbaren akustischen Ausgangspegels des Hörers führen. Diese Zusammenhänge würden sich insbesondere bei Anwendung von programmierbaren elektronischen Stellern in Leistungsendstufen, z.B. Gegentaktendstufen, wegen deren erhöhtem Strombedarf besonders nachteilig auswirken.

Um diesen Nachteil zu vermeiden, hat man bei Hörgeräteschaltungen mit einer Leistungsendstufe auf eine elektronische Begrenzung in der Endstufe verzichtet und die vorgeschaltete Vorstufe mit einem programmierbaren elektronischen Steller als Begrenzungseinrichtung ausgerüstet. Nachteilig ist aber, daß eine derartige Hörgeräteschaltung entweder im Bereich linearer Verstärkung einen erhöhten Klirrfaktor hat oder bei Verringerung des maximalen Ausgangspegels bereits nach wenigen dB die Verstärkung in unerwünschter Weise mit abgesenkt wird.

Ein Hörgerät mit einem als Schalter betriebenen Transistor als Begrenzer ist in der FR-A-2 527 925 beschrieben. Eine ähnliche Schaltung für Kopfhörer ist in der GB-A-2 166 015 angegeben.

Bei Hörgeräteschaltungen mit einem mechanischen Steller (Potentiometer) als Begrenzungseinrichtung muß der Steller wegen der notwendigen Bedienbarkeit an einer Außenwand des Hörgerätes angeordnet werden. Dadurch werden regelmäßig relativ lange Verbindungsleitungen notwendig. In der Null-Ohm-Stellung des Stellers werden diese Leitungen vom maximalen Strom der Endstufe durchflossen. Dadurch wird ein elektromagnetisches Feld erzeugt, das zu unerwünschter Kopplung mit einer in dem Hörgerät vorhandenen Telefonspule führen kann, die bestimmungsgemäß auf elektromagnetische Felder eines Telefones ansprechen soll.

Aufgabe der Erfindung ist es, die geschilderten Nachteile zu vermeiden und für eine Hörgeräteschaltung der eingangs genannten Art eine elektronisch wirkende Begrenzungseinrichtung anzugeben, bei der bei unwirksam gestellter Begrenzung die Verringerung des maximal erreichbaren akustischen Ausgangspegels des Hörers gering bleibt.

Diese Aufgabe wird durch die im Anspruch 1 genannten Merkmale gelöst. An dem erfindungsgemäß vorgesehenen und als stromdurchflossener Schalter betriebenen Halbleiter entsteht allenfalls nur ein äußerst geringer Spannungsabfall im Stromkreis, so daß die Verringerung des maximal erreichbaren akustischen Ausgangspegels des Hörers gering bleibt. Prinzipiell ist der Spannungsabfall an einem als Schalter betriebenen Halbleiter geringer als an einem als Widerstand betriebenen Halbleiter. Ein weiterer wesentlicher Vorteil der erfindungsgemäßen Lösung ist darin zu sehen, daß an dem als Schalter betriebenen Halbleiter der Spannungsabfall bei steigendem Strom, im Gegensatz zu als Widerstand betriebenen Halbleitern, im wesentlichen konstant bleibt. Des weiteren wird erfindungsgemäß der erste steuerbare Halbleiter nicht nur als Schalter betrieben, sondern bei wirksam eingestellter Begrenzungseinrichtung als stromdurchflossener variabler Widerstand. Durch diese Kombination wird der besondere Vorteil erreicht, daß die elektronische Begrenzungseinrichtung im wesentlichen aus nur einem Halbleiter gebildet werden kann, der entsprechend der vorgenommenen Einstellung der Begrenzungswirkung (Begrenzungsgrad) entweder als Schalter oder als variabler Widerstand im Stromkreis der Endstufe wirkt.

In Ausgestaltung der Erfindung weist der erste steuerbare Halbleiter einen Steueranschluß auf, der mit einem einstellbaren Bauteil, z.B. einem programmierbaren elektronischen Widerstand, verbunden ist. Dadurch ergibt sich der Vorteil einer z.B. durch Fernsteuerung vornehmbaren elektronischen Einstellung der elektronischen Begrenzungseinrichtung.

Nach einer vorteilhaften Variante kann der erfindungsgemäß als Schalter betreibbare erste steuerbare Halbleiter als ein die einstellbare elektronische Begrenzungsschaltung überbrückender Schalter im Stromkreis angeordnet werden. Auch durch eine sonach gebildete Parallelschaltung, z.B. zu einem programmierbaren elektronischen Widerstand, können die erfindungsgemäßen Vorteile des als Schalter betriebenen Halbleiters mit denen eines elektronisch programmierbaren Widerstandes bei nur äußerst geringem Bauteileaufwand kombiniert werden, insbesondere, wenn die Begrenzungseinrichtung wenigstens teilweise als Bestandteil einer integrierten Schaltung ausgebildet ist.

Weitere Vorteile und Einzelheiten der Erfindung ergeben sich aus der nachfolgenden Beschreibung von Ausführungsbeispielen anhand der Zeichnungen und in Verbindung mit den Ansprüchen.

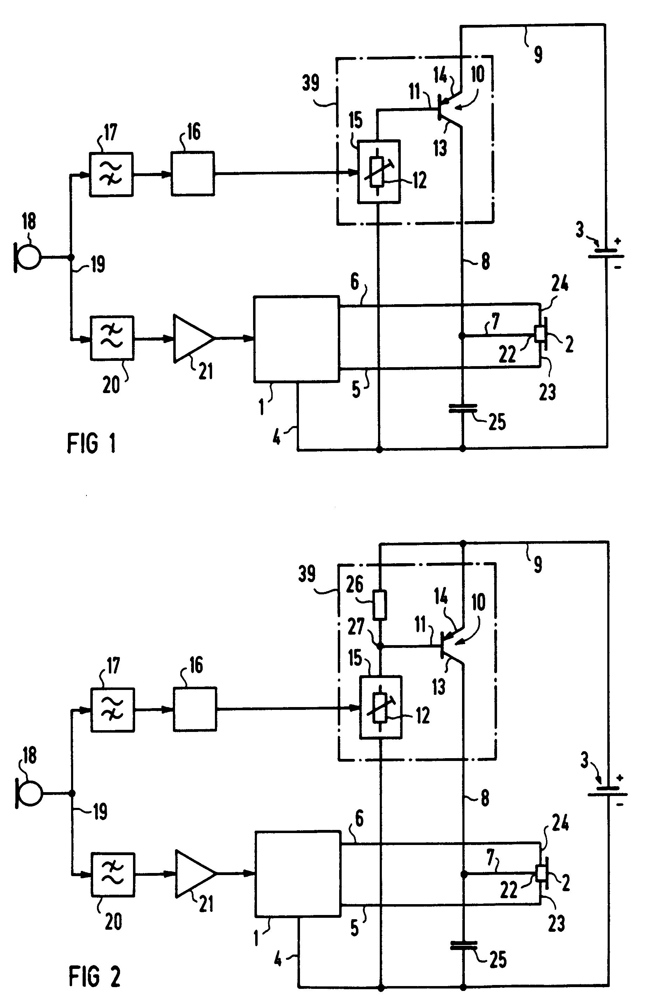

Die Figuren 1 bis 5 zeigen erfindungsgemäße Hörgeräteschaltungen als Blockschaltbilder mit vorteilhaften Varianten und Ausbildungen von einstellbaren elektronischen Begrenzungseinrichtungen.

Die Hörgeräteschaltung gemäß Figur 1 umfaßt eine Endstufe 1, die über einen Hörer 2 mit einer Batterie 3 zu einem Stromkreis verbunden ist. Der Stromkreis ist über Leitungen 4 bis 9 und den Transistor 10 geschlossen. Der Transistor 10 ist ein erster steuerbarer Halbleiter - also ein steuerbares (einstellbares) elektronisches Bauteil - und ist in dieser Hörgeräteschaltung als einstellbare und elektronische Begrenzungseinrichtung verwendet. Die Wirkung der Begrenzungseinrichtung wird unwirksam, d.h. es findet keine Begrenzung statt, wenn der Transistor 10 als stromdurchflossener Schalter in dem Stromkreis betrieben wird. Dies kann z.B. dadurch erfolgen, indem ein Steueranschluß 11 (Basisanschluß) mit einem einstellbaren Bauteil, z.B. einem Steller 12 (Potentiometer od.dgl.), verbunden wird, der seinerseits mit einem Pol der Batterie - in diesem Ausführungsbeispiel mit dem Minuspol - verbunden ist. Für gegen Null gehende Wirkung der Begrenzungseinrichtung wird der Widerstandswert des Stellers 12 mindestens so weit vermindert, daß dem Transistor 10 über den Steueranschluß 11 ein Strom zugeführt wird, der den Transistor 10 durch Übersteuerung leitend werden läßt. Bei ausreichender Übersteuerung wird der Transistor 10 als Schalter betrieben. Der Transistor 10 ist sonach über seine Anschlüsse 13 und 14 (Kollektor-Emitter-Strecke) leitend.

Der Transistor 10 wird nach Verlassen seines Übersteuerungsbereiches als variabler elektronischer Widerstand betrieben. Durch entsprechende Einstellung am Steller 12 werden unterschiedliche Begrenzungsgrade der aus dem Transistor 10 gebildeten elektronischen Begrenzungseinrichtung erreicht. Der Transistor 10 kann sonach als einstellbare und elektronische Begrenzungseinrichtung in unmittelbarer Nähe der Bauteile des Stromkreises plaziert werden, wodurch lange, störende elektrische Felder erzeugende Leitungen vermieden werden. Darüber hinaus wird durch die zugleich mögliche und erfindungsgemäße Betriebsart des Transistors 10 als Schalter der maximal erreichbare akustische Ausgangspegel des Hörers 2 praktisch so gut wie nicht mehr vermindert.

Es ist vorteilhaft, wenn der Transistor 10 eine hohe Stromverstärkung aufweist. Dadurch kann der maximale Stromfluß durch den Steller 12 besonders niedrig bleiben. Der Steller 12 läßt sich daher auch bei Verwendung von langen Leitungen an einer Außenwand eines Hörgerätes plazieren. Darüber hinaus kann der Steller 12 sogar bei unwirksamer Begrenzung einen relativ hohen Widerstandswert aufweisen. Somit läßt sich anstelle des Stellers 12 problemlos ein programmierbarer elektronischer Steller 15 verwenden. Der Steller 15 kann z.B. über ein Fernsteuerempfangsteil 16 programmiert werden, das Fernsteuersignale, z.B. pulsdauermodulierte Ultraschallsignale, über einen Hochpaß 17 und ein Mikrofon 18 zur Auswertung und Aufbereitung erhält. Das Mikrofon 18 kann zugleich Sprachsignale und Umgebungsgeräusche aufnehmen, die über eine Signalverzweigung 19 einem Tiefpaßfilter 20 und einem nachgeschalteter Verstärker 21 zugeführt werden, der mit der Endstufe 1, z.B. über einen nicht dargestellten Lautstärkesteller, verbunden ist.

In der Hörgeräteschaltung gemäß Figur 1 ist die Endstufe 1 als Gegentaktendstufe und der Hörer 2 als Gegentakthörer ausgebildet. Dieser Gegentakthörer hat einen Mittelanschluß 22 und zwei mit der Gegentaktendstufe 1 über die Leitungen 5 und 6 verbundene Anschlüsse 23 und 24. Der Transistor 10 (erster steuerbarer Halbleiter der Begrenzungseinrichtung) ist mit dem ersten Anschluß 14 (Emitteranschluß) über die Leitung 9 mit dem Pluspol der Batterie 3 und mit dem zweiten Anschluß 13 (Kollektoranschluß) über die Leitungen 7 und 8 mit dem Mittelanschluß 22 des Gegentakthörers 2 verbunden. Zur Unterdrückung von unerwünschten Schwingungen dient ein Kondensator 25, der mit dem Mittelanschluß 22 des Hörers 2 und dem Minuspol der Batterie 3 verbunden ist.

Die in Figur 2 dargestellte Hörgeräteschaltung unterscheidet sich von der Hörgeräteschaltung gemäß Figur 1 durch einen ersten Widerstand 26. Dieser erste Widerstand 26 ist mit dem einstellbaren Bauteil, z.B. dem programmierbaren elektronischen Steller 15, zu einem ersten Spannungsteiler verbunden, der zwischen den beiden Polen der Batterie 3 zur Teilung der Batteriespannung angeordnet ist. Dieser erste Spannungsteiler weist einen Spannungsabgriff 27 auf, der mit dem Steueranschluß 11 (Basisanschluß) des ersten steuerbaren Halbleiters (Transistor 10) verbunden ist. Bei programmierbaren elektronischen Stellern ist der Widerstandseinstellbereich häufig auch zu höheren Widerstandswerten hin eingeschränkt. Mit dem ersten Widerstand 26 kann der Einstellbereich der Steller 12 bzw. 15 an den als einstellbare und elektronische Begrenzungseinrichtung vorgesehenen Transistor 10 angepaßt werden.

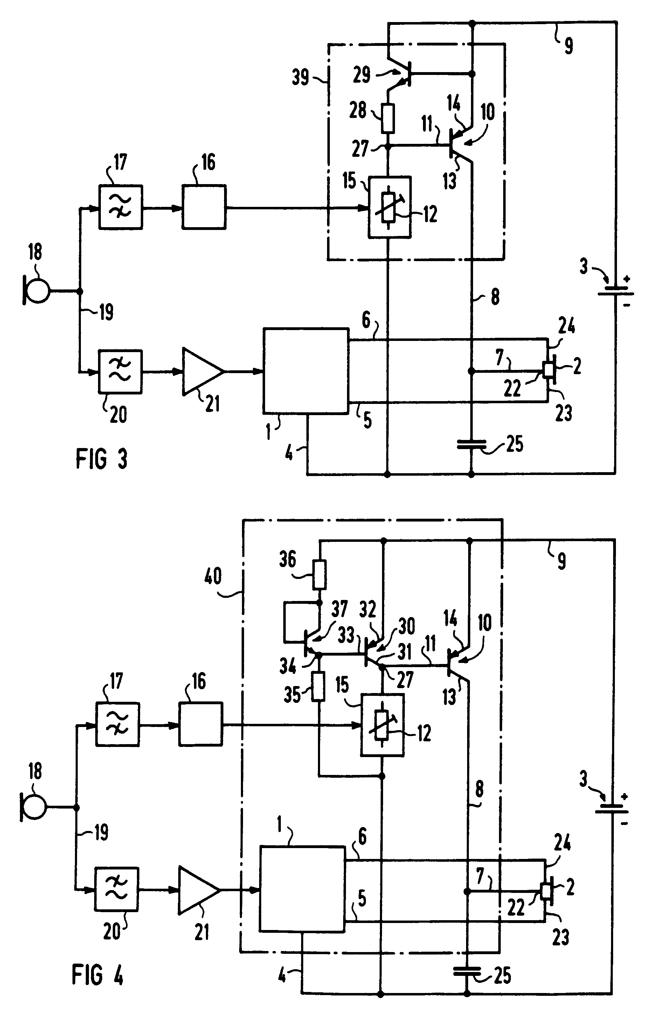

Abweichend von Figur 2 ist in Figur 3 beim ersten Spannungsteiler der erste Widerstand aus einer Reihenschaltung gebildet, die den Widerstand 28 mit festem Widerstandswert und einen zweiten Halbleiter, einen Transistor 29, umfaßt, der einen spannungsabhängigen, nichtlinearen Widerstandswert aufweist. Der Transistor 29 ist ein als Diode geschalteter bipolarer Transistor und komplementär zum ersten steuerbaren Halbleiter, dem Transistor 10, als NPN-Typ dotiert. Durch diese Maßnahmen läßt sich eine Verbesserung der Konstanz des maximalen akustischen Ausgangspegels des Hörers 2 bei sinkender Versorgungsspannung erreichen. Bei sinkender Versorgungsspannung beginnt der Transistor 29 zu sperren. Damit ändert sich das Spannungsteilerverhältnis zwischen dem Widerstand 28 und dem Steller 12 bzw. 15 sowie der Basis-Emitter-Diode im Transistor 10, so daß im Ergebnis die Basis-Emitter-Spannung und damit auch der Basisstrom des Transistors 10 und letztlich die eingestellte Begrenzung annähernd konstant bleiben.

Gemäß Figur 4 ist der erste Spannungsteiler aus dem Steller 12 bzw. aus dem programmierbaren elektronischen Steller 15 und einem zweiten, mindestens drei Anschlüsse aufweisenden steuerbaren Halbleiter, dem Transistor 30, gebildet. Der Transistor 30 ist ein bipolarer Transistor und als PNP-Typ dotiert. Seine Kollektor-Emitter-Strecke ist über die beiden Anschlüsse 31 und 32 entsprechend dem ersten Widerstand 26 in Figur 2 zu der Basis-Emitter-Strecke des Transistors 10 parallelgeschaltet. Der Transistor 30 weist einen Steueranschluß 33 (Basisanschluß) auf, der mit einem Spannungsabgriff 34 mit einem zweiten Spannungsteiler verbunden ist. Der zweite Spannungsteiler ist aus einer Reihenschaltung von zwei Widerständen 35 und 36 mit festem Widerstandswert und aus einem dritten Halbleiter, einem Transistor 37, gebildet. Der Transistor 37 weist einen spannungsabhängigen, nichtlinearen Widerstandswert auf, ist als Diode geschaltet, als bipolarer Transistor ausgeführt, als NPN-Typ dotiert und damit komplementär gegenüber dem ersten steuerbaren Halbleiter 10 und dem zweiten steuerbaren Halbleiter 30 in Figur 4 dotiert. Die Hörgeräteschaltungsanordnung gemäß Figur 4 erlaubt es, sowohl Hörer mit niederohmiger als auch mit hochohmiger Impedanz an eine einstellbare elektronische Begrenzungsschaltung anzupassen. Wenn als Steller ein programmierbarer elektronischer Steller gewählt ist, mit dem bauarttypisch nur eine bestimmte Anzahl von Widerstandswerten programmierbar ist, läßt sich darüber hinaus ein derartiger elektronischer Steller ebenfalls mit der in Figur 4 gezeigten Hörgeräteschaltung sowohl an die elektronische Begrenzungseinrichtung als auch an die jeweilige Hörerimpedanz anpassen.

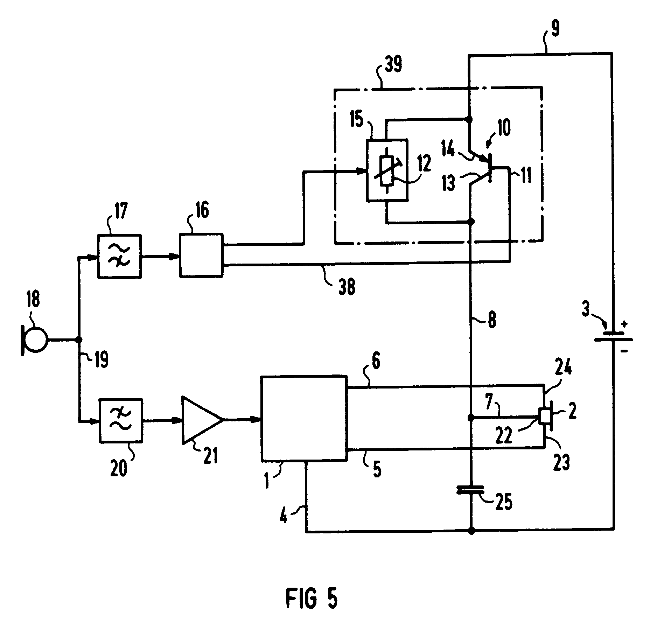

In Figur 5 weist die Hörgeräteschaltung eine einstellbare elektronische Begrenzungseinrichtung auf, bei der der erste steuerbare Halbleiter, der Transistor 10, als ein die einstellbare Begrenzungsschaltung überbrückender Schalter in dem Stromkreis angeordnet ist. Die einstellbare Begrenzungsschaltung umfaßt als programmierbaren elektronischen Widerstand den Steller 15, der über eine Fernsteuerung programmierbar ist, wie es z.B. in der Beschreibung zu Figur 1 dargelegt ist. Der Fernsteuerempfangsteil 16 schaltet zusätzlich über eine Leitung 38 und über den Steueranschluß 11 den Transistor 10 zur Einstellung einer unwirksamen Begrenzung in den leitenden Bereich (Schalterbetrieb), wodurch der Strom im Stromkreis der Endstufe 1 nicht mehr über den elektronischen Steller 15 fließt. Im Falle einer eingestellten Begrenzung wird der Transistor 10 gesperrt (Sperrbetrieb), was durch ein entsprechendes Schaltsignal, z.B. Spannungsfreiheit auf der Leitung 38, aus dem Fernsteuerempfangsteil 16 bewirkt wird.

Die elektronische Begrenzungseinrichtung kann vollständig oder teilweise als Bestandteil einer integrierten Schaltung ausgebildet werden, wie es durch eine strichlierte Begrenzungslinie 39 in Figur 5 und in den Figuren 1 bis 3 symbolisch angegeben ist. Darüber hinaus kann die Begrenzungseinrichtung ganz oder teilweise auch zusammen mit der Endstufe 1 als gemeinsame integrierte Schaltung ausgebildet werden, wie es durch eine strichlierte Begrenzungslinie 40 in Figur 4 symbolisch dargestellt worden ist.

Die elektronische Begrenzungseinrichtung, wie sie z.B. in Figur 1 dargestellt ist, kann auch über eine Strom- oder Spannungsquelle gesteuert (eingestellt) werden, die z.B. über eine Fernsteuerung programmierbar sein kann. Dazu wird das einstellbare Bauteil, das mit dem Steueranschluß 11 des Transistors 10 verbunden ist, als Strom- oder Spannungsquelle ausgebildet. In Verbindung mit einem integrierten Schaltkreis (IC) läßt sich eine derartige Ausbildung der Begrenzungseinrichtung günstig realisieren.

Die Anordnung der elektronischen Begrenzungseinrichtung kann an anderer Stelle im Stromkreis der Endstufe 1 der erfindungsgemäßen Hörgeräteschaltung erfolgen. So ist es z.B. möglich, in jeder Leitung 5 und 6 gemäß Figur 1 jeweils eine elektronische Begrenzungseinrichtung anzuordnen.

Wenigstens ein Halbleiter der elektronischen Begrenzungseinrichtung kann auch als unipolarer Transistor - Feldeffekttransistor - ausgebildet sein.

## Patentansprüche

1. Hörgeräteschaltung mit einer Endstufe (1), die über einen Hörer (2) und eine Batterie (3) zu einem Stromkreis verbindbar ist, der zur Begrenzung (Clippung) des maximalen akustischen Ausgangspegels des Hörers (2) eine einstellbare Begrenzungseinrichtung aufweist, die elektronisch ausgebildet ist und wenigstens einen ersten steuerbaren Halbleiter (10) umfaßt, der mittels eines einstellbaren Bauteiles (12, 15) bei einer unwirksamen Begrenzung als stromdurchflossener Schalter und bei einer wirksamen Begrenzung als stromdurchflossener variabler Widerstand im Stromkreis betreibbar ist.

2. Hörgeräteschaltung nach Anspruch 1, bei der der erste steuerbare Halbleiter (10) einen Steueranschluß (11) aufweist, der mit dem einstellbaren Bauteil (12, 15) verbunden ist.

3. Hörgeräteschaltung nach Anspruch 1 oder 2, bei der das einstellbare Bauteil (12, 15) ein programmierbarer elektronischer Widerstand (15) ist.

4. Hörgeräteschaltung nach einem der Ansprüche 1 bis 3, bei der für gegen Null gehende Wirkung der Begrenzungseinrichtung dem ersten steuerbaren Halbleiter über das einstellbare Bauteil (12, 15) ein Strom zugeführt wird, der den ersten steuerbaren Halbleiter (10) durch Übersteuerung leitend werden läßt.

5. Hörgeräteschaltung nach einem der Ansprüche 1 bis 4, bei der die Endstufe (1) als Gegentaktendstufe und der Hörer (2) als Gegentakthörer ausgebildet ist, der einen Mittelanschluß (22) und zwei mit der Gegentaktendstufe verbundene Anschlüsse (23, 24) aufweist, wobei der erste steuerbare Halbleiter (10) der Begrenzungseinrichtung mit einem ersten Anschluß (14) mit der Batterie (3) und mit einem zweiten Anschluß (13) mit dem Mittelanschluß (22) des Gegentakthörers (2) verbunden ist.

6. Hörgeräteschaltung nach einem der Ansprüche 2 bis 5, bei der das einstellbare Bauteil (12, 15) und wenigstens ein erster Widerstand (26) zu einem die Spannung der Batterie (3) teilenden ersten Spannungsteiler verbunden sind, der einen Spannungsabgriff (27) aufweist, der mit dem Steueranschluß (11) des ersten steuerbaren Halbleiters (10) elektrisch verbunden ist.

7. Hörgeräteschaltung nach Anspruch 6, bei der der erste Widerstand (26) des ersten Spannungsteilers aus einer Reihenschaltung eines Widerstandes (28) mit festem Widerstandswert und aus einem zweiten Halbleiter (29) gebildet ist, der einen spannungsabhängigen nichtlinearen Widerstandswert aufweist.

8. Hörgeräteschaltung nach Anspruch 7, bei der der zweite Halbleiter ein als Diode geschalteter Transistor (29) ist.

9. Hörgeräteschaltung nach Anspruch 6, bei der der erste Widerstand (26) des ersten Spannungsteilers ein zweiter, mindestens drei Anschlüsse aufweisender steuerbarer Halbleiter (30) ist, dessen Steueranschluß (33) mit einem Spannungsabgriff (34) an einem zweiten Spannungsteiler verbunden ist, der aus einer Reihenschaltung von zwei Widerständen (35, 36) mit festem Widerstandswert und aus einem dritten Halbleiter (37) gebildet ist, der einen spannungsabhängigen nichtlinearen Widerstandswert aufweist.

10. Hörgeräteschaltung nach Anspruch 9, bei der der dritte Halbleiter ein als Diode geschalteter Transistor (37) ist.

11. Hörgeräteschaltung nach Anspruch 1, bei der der erste steuerbare Halbleiter (10) als ein die einstellbare elektronische Begrenzungseinrichtung überbrückender Schalter im Stromkreis angeordnet ist.

12. Hörgeräteschaltung nach Anspruch 1 oder 11, bei der die einstellbare Begrenzungseinrichtung einen programmierbaren elektronischen Widerstand (15) umfaßt, der über eine Fernsteuerung und/oder ein Programmiergerät programmierbar ist.

13. Hörgeräteschaltung nach einem der Ansprüche 1 bis 12, bei der wenigstens für den ersten Halbleiter der Begrenzungseinrichtung ein bipolarer Transistor (10) gewählt ist.

14. Hörgeräteschaltung nach einem der Ansprüche 1 bis 13, bei der die Begrenzungseinrichtung wenigstens teilweise als Bestandteil einer integrierten Schaltung (39) ausgebildet ist.

15. Hörgeräteschaltung nach einem der Ansprüche 1 bis 14, bei der die Begrenzungseinrichtung wenigstens teilweise zusammen mit der Endstufe (1) als gemeinsame integrierte Schaltung (40) ausgebildet ist.

## Claims

1. Hearing-aid circuit having an output stage (1) which can be connected to an electric circuit by way of a receiver (2) and a battery (3), the electric circuit having an adjustable limiting device to limit (clip) the maximum acoustic output level of the receiver (2), the limiting device being constructed electronically and comprising at least a first controllable semiconductor (10) which can be operated by means of an adjustable component (12, 15) with an inefficient limitation as current-carrying switch and with efficient limitation as current-carrying variable resistance in the electric circuit.

2. Hearing-aid circuit according to claim 1, where the first controllable semiconductor (10) has a control terminal (11) which is connected to the adjustable component (12, 15).

3. Hearing-aid circuit according to claim 1 or 2, where the adjustable component (12, 15) is a programmable electronic resistance (15).

4. Hearing-aid circuit according to one of claims 1 to 3, with a current being supplied for action of the limiting device going towards zero to the first controllable semiconductor by way of the adjustable component (12, 15), which current makes the first controllable semiconductor (10) conductive through overdriving.

5. Hearing-aid circuit according to one of claims 1 to 4, where the output stage (1) is constructed as push-pull output stage and the receiver (2) is constructed as push-pull receiver, having a centre terminal (22) and two terminals (23, 24) connected to the push-pull output stage, with the first controllable semiconductor (10) of the limiting device being connected to a first terminal (14) with the battery (3) and to a second terminal (13) with the centre terminal (22) of the push-pull receiver (2).

6. Hearing-aid circuit according to one of claims 2 to 5, where the adjustable component (12, 15) and at least a first resistance (26) are connected to a first voltage divider dividing the voltage of the battery (3), the voltage divider having a voltage tap (27) which is electrically connected to the control terminal (11) of the first controllable semiconductor (10).

7. Hearing-aid circuit according to claim 6, where the first resistance (26) of the first voltage divider is formed from a series connection of a resistance (28) with fixed resistance value and from a second semiconductor (29) which has a voltage-dependent non-linear resistance value.

8. Hearing-aid circuit according to claim 7, where the second semiconductor is a transistor (29) connected as diode.

9. Hearing-aid circuit according to claim 6, where the first resistance (26) of the first voltage divider is a second controllable semiconductor (30) having at least three terminals, the control terminal (33) of which semiconductor is connected to a voltage tap (34) at a second voltage divider, which is formed from a series connection of two resistances (35, 36) with fixed resistance value and from a third semiconductor (37) which has a voltage-dependent nonlinear resistance value.

10. Hearing-aid circuit according to claim 9, where the third semiconductor is a transistor (37) connected as diode.

11. Hearing-aid circuit according to claim 1, where the first controllable semiconductor (10) is arranged in the electric circuit as a switch bridging the adjustable electronic limiting device.

12. Hearing-aid circuit according to claim 1 or 11, where the adjustable limiting device comprises a programmable electronic resistance (15) which can be programmed by way of a remote control and/or a programming device.

13. Hearing-aid circuit according to one of claims 1 to 12, where a bipolar transistor (10) is chosen at least for the first semiconductor of the limiting device.

14. Hearing-aid circuit according to one of claims 1 to 13, where the limiting device is constructed at least partially as a component part of an integrated circuit (39).

15. Hearing-aid circuit according to one of claims 1 to 14, where the limiting device is constructed at least partially together with the output stage (1) as a common integrated circuit (40).

## Revendications

1. Circuit pour un appareil de correction auditive, comportant un étage final (1), qui peut être relié, par l'intermédiaire d'un écouteur (2) et d'une pile (3), à un circuit qui, pour limiter (clipping) le niveau de sortie acoustique maximum de l'écouteur (2), possède un dispositif réglable de limitation, qui est conçu électroniquement et comprend au moins un premier semiconducteur commandable (10), qui, au moyen d'un composant réglable (12,15) et dans le cas d'une limitation inactive, peut fonctionner en tant qu'interrupteur parcouru par le courant et, dans le cas d'une limitation active, peut fonctionner en tant que résistance variable parcourue par le courant, dans le circuit.

2. Circuit pour un appareil de correction auditive suivant la revendication 1, dans lequel le premier semiconducteur commandable (10) possède une borne de commande (11), qui est reliée au composant réglable (12,15).

3. Circuit pour un appareil de correction auditive suivant la revendication 1 ou 2, dans lequel le composant réglable (12,15) est une résistance électronique programmable (15).

4. Circuit pour un appareil de correction auditive suivant l'une des revendications 1 à 3, dans lequel, pour obtenir une action du dispositif de limitation tendant à s'annuler, au premier semiconducteur commandable est envoyé, par l'intermédiaire du composant réglable (12,15), un courant qui, par surmodulation, rend passant le premier semiconducteur commandable (10).

5. Circuit pour un appareil de correction auditive suivant l'une des revendications 1 à 4, dans lequel l'étage final (1) est réalisé sous la forme d'un étage final push-pull et l'écouteur (2) est réalisé sous la forme d'un écouteur push-pull qui possède une borne médiane (22) et deux bornes (23,24) reliées à un étage final push-pull, le premier semiconducteur commandable (10) et le dispositif de limitation étant reliés par une première borne (14) à la pile (3) et par une seconde borne (13) à la borne médiane (22) de l'écouteur push-pull (2).

6. Circuit pour un appareil de correction auditive suivant l'une des revendications 2 à 5, dans lequel le composant réglable (12,15) et au moins une première résistance (26) sont reliés pour former un premier diviseur de tension qui divise la tension de la pile (3) et qui possède une prise de tension (27), qui est reliée électriquement à la borne de commande (11) du premier semiconducteur commandable (10).

7. Circuit pour un appareil de correction auditive suivant la revendication 6, dans lequel la première résistance (26) du premier diviseur de tension est constituée par un circuit série formé d'une résistance (28) possédant une valeur résistive fixe et par un second semiconducteur (29), qui possède une valeur résistive non linéaire, qui dépend de la tension.

8. Circuit pour un appareil de correction auditive suivant la revendication 7, dans lequel le second semiconducteur est un transistor (29) branché en diode.

9. Circuit pour un appareil de correction auditive suivant la revendication 6, dans lequel la première résistance (26) du premier diviseur de tension est un second semiconducteur commandable (30), qui possède au moins trois bornes, parmi lesquelles la borne de commande (33) est reliée à une prise de tension (34) située sur un second diviseur de tension qui est formée par un circuit série constitué de deux résistances (35,36) possédant une valeur résistive fixe et par un troisième semiconducteur (37), qui possède une valeur résistive non linéaire qui dépend de la tension.

10. Circuit pour un appareil suivant la revendication 9, dans lequel le troisième semiconducteur est un transistor (37) branché en diode.

11. Circuit pour un appareil de correction auditive suivant la revendication 1, dans lequel le premier semiconducteur commandable (10) est disposé dans le circuit sous la forme d'un interrupteur qui shunte le dispositif électronique réglable de limitation.

12. Circuit pour un appareil de correction auditive suivant la revendication 1 ou 11, dans lequel le dispositif réglable de limitation comprend une résistance électronique programmable (15), qui peut être programmée par l'intermédiaire d'une télécommande et/ou d'un appareil programmable.

13. Circuit pour un appareil de correction auditive suivant l'une des revendications 1 à 12, dans lequel un transistor bipolaire (10) est choisi au moins pour le premier semiconducteur du dispositif de limitation.

14. Circuit pour un appareil de correction auditive suivant l'une des revendications 1 à 13, dans lequel le dispositif de limitation est agencé au moins en partie en tant que composant d'un circuit intégré (39).

15. Circuit pour un appareil de correction auditive suivant l'une des revendications 1 à 14, dans lequel le dispositif de limitation est réalisé, au moins en partie, conjointement avec l'étage final (1) sous la forme d'un circuit intégré commun (40).
